# EUROPEAN PATENT APPLICATION

(11) **EP 2 262 205 A2**
(43) Date of publication of application: **15.12.2010**
(21) Application number: 10179597.9
(22) Date of filing: 09.12.2002
(51) Int. Cl.: H04M 1/02

(54) **Intelligent multi-media display communication system**

(30) Priority: 12.12.2001 US 20336; 06.12.2002 US 313678
(62) Divisional of application: 02795779.4
(71) Applicant: Universal Display Corporation, Ewing, NJ 08618 (US)
(72) Inventor: The designation of the inventor has not yet been filed
(74) Representative: Ackroyd, Robert

(57) **Abstract**

Interactive, low power, collapsible, intelligent, multi-media display systems (100) for use as hand-held, portable communications devices are disclosed. A display communications device according to the invention can include a housing (102) that contains a processor, radio transceiver means for transmitting and receiving radio signals, and a collapsible display (106) that is mechanically coupled to the housing and electrically coupled to the processor. The display can have a surface area that is larger than any cross-sectional area of the housing. The processor can be adapted to extract display data from input radio signals, and to provide a representation of the display data to the display.

## Description

### FIELD OF THE INVENTION

This invention relates to display systems. More particularly, the invention relates to interactive, low power, collapsible, intelligent, multi-media display systems for use as hand-held, portable communications devices.

### BACKGROUND OF THE INVENTION

As the demand increases for hand-held, portable communications devices such as telephones, personal digital assistants (PDAs), and the like, so does the demand that such devices provide increased capabilities. For example, consumers are demanding hand-held devices that include telephone capability, paging, fax, wireless internet access, data storage, and so forth. At the same time, however, consumers are demanding that manufacturers continue to decrease the size of such devices.

Such hand-held devices typically include displays. A problem manifested by the decreased size of these devices is that the displays are often too small to provide much information, and the information that can be provided is usually not provided in a visually appealing manner. For example, a typical light emitting diode (LED) display or liquid crystal display (LCD) on a small, hand-held telephone or PDA can be unclear and might not be able to display an adequate amount of information. For example, such a display typically cannot display an entire Web page. Additionally, such displays are often not full-color displays.

Typical prior art hand held communications devices include a housing that contains the processing electronics for the device. The housing is the part of the device that the user holds in his hand and, accordingly, is typically designed to fit comfortably into a human hand. The display is typically integrated into the housing. Consequently, the size of the display is limited by the size of the housing. Additionally, the manufacturer's ability to decrease the size of the device is impeded because such displays typically require a relatively large amount of electrical energy and, therefore, that the housing contain a relatively large power supply.

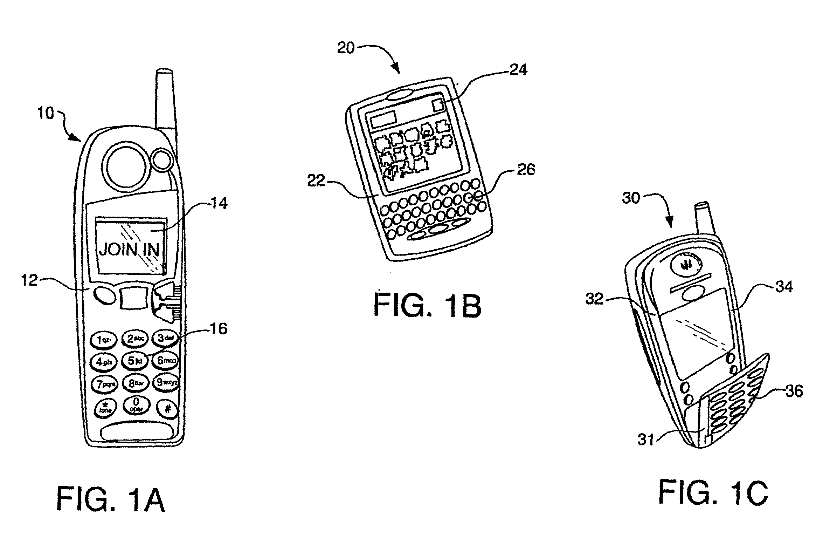

FIGs. 1A-1C depict several typical prior art hand held communications devices. FIG. 1A depicts a hand held telephone 10 having a housing 12 and a display 14 that is integrated into the housing 12. As shown, the display 14 is smaller than the housing 12. The telephone 10 includes a keypad 16 that includes a plurality of buttons that the user can use to operate the device. The keypad 16 is separate from the display 14.

Similarly, FIG. 1B depicts a personal digital assistant 20 having a housing 22 and a display 24 that is integrated into the housing 22. Again, the display 24 is smaller than the housing 22. The PDA 20 includes a keyboard 26 that the user can use to operate the device 20. The keyboard 26 is separate from the display 24.

FIG. 1C depicts a so-called flip phone 30 having a housing 32 and a display 34 that is integrated into the housing 32. As shown, the display 34 is smaller than the housing 32. When the flip cover 31 is closed, it covers a portion of the display 34. The flip cover 31 can be opened to reveal the covered portion of the display 34. Alternatively, the display 34 could be integrated into the flip cover 31 of the phone 30. As the flip cover 31 has a surface area that is no bigger than the surface area of the housing 32, the display 34 is smaller than the housing 32 in any event. The flip phone 30 includes a keypad 36, which is separate from the display 34.

In each case, the display is merely one of several elements that is integrated into (or otherwise coupled to) the housing of the device. In each case, the display is small, rigid, fixed in size, and generally rectangular in shape. Consequently, the displays are of limited utility in providing meaningful information to the user. Thus, there is a need in the art for intelligent multi-media display communications systems.

### SUMMARY OF THE INVENTION

The invention provides an interactive, low power, collapsible, intelligent, multi-media display system according to the invention. Such display systems can be used as hand-held, portable communications devices. A display communications device according to the invention can be an interactive, bi-directional communications device that includes a housing that can contain a processor; radio transceiver means for transmitting and/or receiving radio signals; and a collapsible display that is mechanically coupled to the housing. The display can have a surface area that is larger than any cross-sectional area of the housing. The housing can contain a low voltage power supply, such as a thin film power supply.

A processor can be contained within the housing and can be adapted to receive commands from the display and to form the output radio signals based on the received commands. The display can be adapted to process touch commands, and the received commands can be based on the touch commands. A speaker can be coupled to the processor for transmitting output audio signals, and the processor can be adapted to extract audio data from the input radio signals, and to provide to the speaker output audio signals that are representative of the extracted audio data. A microphone can be coupled to the processor for receiving input audio signals, and the processor can be adapted to form output radio signals based on the input audio signals. The processor can be adapted to form the output radio signals by modulating a carrier signal with a representation of the input audio signal.

The device can be voice activated. The processor can be adapted to determine whether the input audio signals are telephone signals or commands. The processor can initiate a connection between the display communications device and a remote network device, such as by a connection to the internet. The processor is adapted to determine whether the device is in a telephone mode or a command mode. If the device is in command mode, the processor is adapted to respond to voice activation commands. The display can be a flexible display. The communications device can include a rod that is coupled to the housing and to the display such that the display can be wound around the rod. The rod can be coupled to the interior or the exterior of the housing. Alternatively, the display can be wound around the housing itself. The device can include a locking mechanism for holding the display in an extended position. The display can be a foldable display.

The display can be touch responsive. The display can provide touch signals to the processor and the processor can perform responsive operations in response to receiving the touch signals. The display communications device can also include display memory for storing display data that corresponds to information currently being displayed. The display memory can be embedded into the display (*e.g.*, in the pixels themselves), or contained in the housing.

The display can include a plurality of organic light emitting devices (OLEDs). The OLEDs can be ordinary, side-by-side OLEDs, stacked OLEDs (SOLEDs), or top-emitting or transparent OLEDs (TOLEDs), for example. Additionally, the OLEDs can be integrated with organic photodetectors.

The display can include a plurality of bistable pixels. The display can include a plurality of self-configurable pixels. Each pixel can include a local processor and a memory that contains a pixel address associated with the pixel. The pixels can be adapted to configure themselves with respect to color, grayscale, and/or resolution. The pixels can include groups of sub-pixels, where each sub-pixel includes a number of light emitting devices. The number of light emitting devices that form a sub-pixel can depend on the color(s), grayscale, and resolution of the pixel.

The processor can update the display by providing a data packet that includes a pixel address and a brightness that corresponds to a pixel located at the pixel address. The processor can be adapted to compare a current image with a previous image, and to identify one or more pixels having a pixel brightness that needs to be changed to convert the display from the previous image to the current image. The processor can provide the display with display data that causes the pixel brightness of the one or more identified pixels to change. A pixel can include one or more colored or infrared sub-pixels.

The display can be removably coupled to the housing, and adapted to be removably coupled to each of a plurality of external devices. The display can be adapted to automatically configure to the external device to which it is coupled.

### BRIEF DESCRIPTION OF THE SEVERAL VIEWS OF THE DRAWING

Other features of the invention are further apparent from the following detailed description of the embodiments of the present invention taken in conjunction with the accompanying drawing.
FIGs. 1A-1C depict typical prior art hand-held communications devices having relatively small displays that are integrated into their respective housings.
FIGs. 2A-2E depict preferred embodiments of an intelligent multi-media display communications system according to the invention.
FIGs. 3A-3C depict a preferred embodiment of a display communications system according to the invention having a collapsible display.
FIG. 4 depicts a preferred embodiment of a display communications system according to the invention having a touch responsive display with a telephone keypad.
FIG. 5 depicts a preferred embodiment of a display communications system according to the invention a display having a touch responsive display with a keyboard.
FIG. 6 depicts a preferred embodiment of a display communications system according to the invention a full color display capable of displaying an entire Web page.
FIG. 7 depicts a preferred display communications system according to the invention having a display extension.
FIG. 8 depicts a carrying case for containing a display communications device according to the invention.
FIGs. 9A-9D depict alternative embodiments of pixels that can be used in a display according to the invention.
FIGs. 10A-10F depict alternative embodiments of the invention having collapsible housings.

### DETAILED DEBCRIPTION OF THE INVENTION

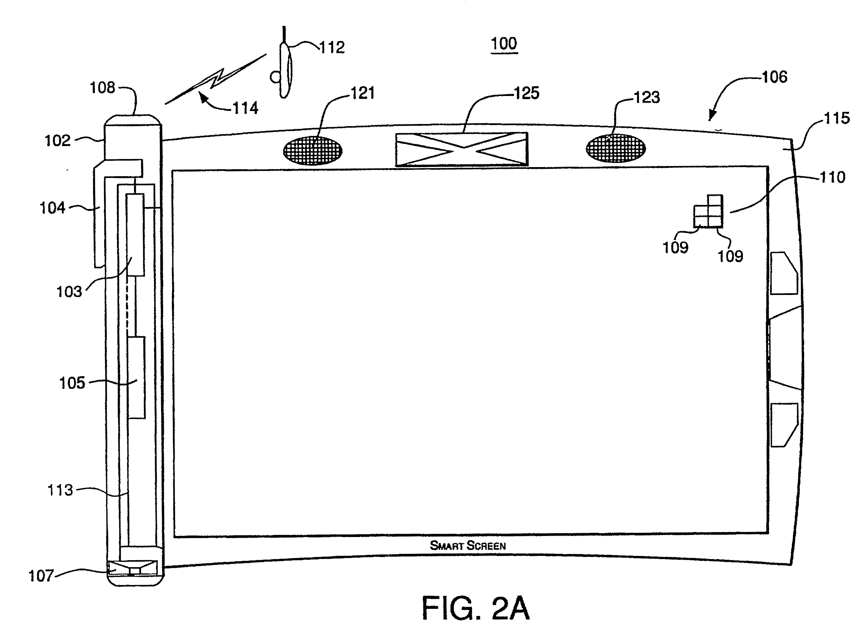

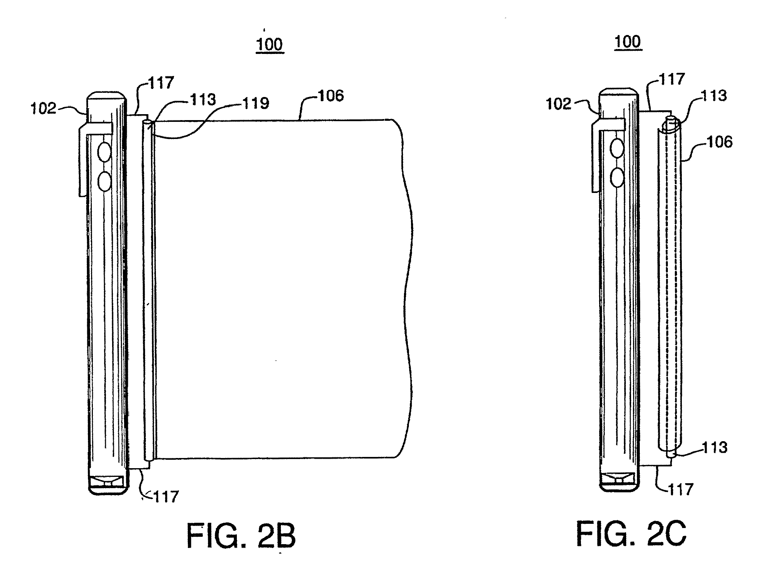

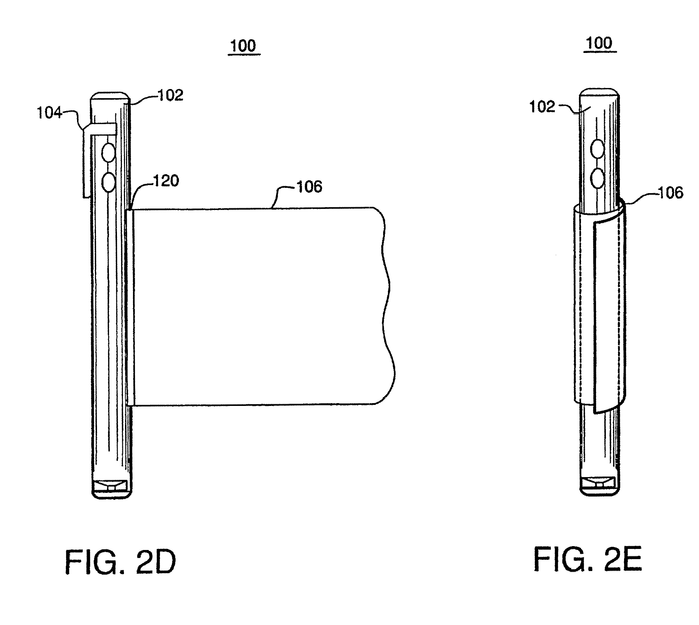

FIG. 2 depicts a preferred embodiment of an intelligent multi-media display communications device 100 according to the invention. As shown, the device 100 includes a housing 102 that contains a processor 103, which includes the primary processing electronics for operating the device 100. Preferably, the device 100 is a hand-held or pocket-sized device that has an overall shape similar to that of a pen or pointer, for example, as shown. In such an embodiment, the housing 102 is an elongated, narrow housing. Preferably, the device 100 includes a dispenser that contains ink or solid or liquid graphite so that it can actually be used as a writing implement as well as a communication device. The housing 102 can be made of plastic, for example.

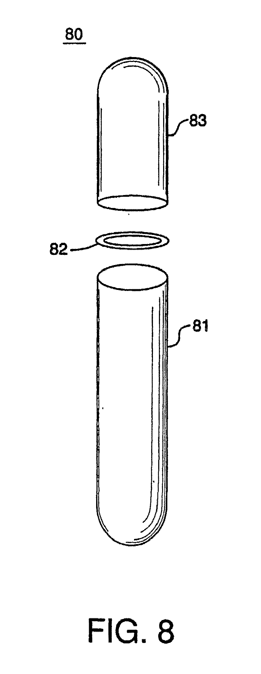

The housing 102 can also contain a micro-fan that provides cooling for internal components, as well as positive pressure inside the housing to thereby keep particles, such as dust, sand, and smoke particles, for example, from entering the device and contaminating the internal components. Additionally, a carrying case can be provided to protect the device 100 from water, dust, and the like. Such a carrying case is depicted in FIG. 8. Preferably, the carrying case 80 is made of metal, plastic, or the like, with an optional hermetic seal 82 to protect the device from impact and environmental conditions. Preferably, the carrying case 80 includes a hollow, elongated body portion 81 and a hollow elongated cap portion 83, and has an overall tubular shape (such as that of a cigar tube). Preferably, the cap portion 83 is detachably coupled to the body portion 81. For example, the carrying case can be designed so that the cap portion 83 can be slid onto and off of the body portion 81 or threaded onto and off of the body portion 81. Accordingly, the cap portion 83 and the body portion 81 can each include complementary threads (not shown in Fig. 8) so that the cap portion 83 can be threaded onto or off of the body portion 81.

Though the hermetic seal 82 can be a separate element, it is preferred that the hermetic seal 82 is attached to either the body portion 81 or the cap portion 83. In any event, the hermetic seal 82 is disposed between the cap portion 83 and the body portion 81 so that the carrying case 80 is hermetically sealed when the cap portion 83 is coupled to the body portion 81. It is anticipated that the device housing will likely be on the order of one inch in diameter. Consequently, it is anticipated that the carrying case 80 will likely have an interior diameter 80d of about one inch as well.

The processor 103 can include, but is not limited to, a microprocessor. Preferably, the processor 103 is a thin film "digital radio on a chip." That is, the processor 103 provides the capability for processing of analog and digital radio signals. Such processing can include any number of signal processing techniques, including data encryption to provide communications that are secure from third party interception, noise reduction, background noise cancellation, echo cancellation, and other such techniques for the improvement of sound quality. Data encryption/decryption capabilities are preferably provided so that the device can receive, process, and transmit encrypted communications signals. Thus, the device can be made secure from possible third-party interception. Any well-known data encryption/decryption techniques can be employed (*e.g.* RSA, Diffie-Hellman, DES, Triple-DES, etc.).

The processor 103 can also provide compound radio capabilities (*i.e.,* multiple radios or radio functions on a chip). For example, the device 100 can be adapted to transmit, process, and receive short range, infrared signals, or short, intermediate, or long range radio-frequency (RF) signals, depending on the particular characteristics of the environment, the application, and the external device with which the display communications device 100 is communicating. Such radio capabilities can be implemented in software on the processor 103.

Preferably, the processor 103 includes control means for selectively and/or simultaneously controlling the transmission and receipt of communications signals that contain audio, video, and/or control data. Additionally, the processor 103 preferably includes control means for selectively and/or simultaneously controlling the display or storage of audio, video, and/or control data that the device receives. A detailed description of the functions that the processor 103 can perform in a preferred embodiment of the invention is provided below.

The device 100 includes radio transceiver means 104, such as an antenna, for example, for transmitting output radio signals and receiving input radio signals. The radio signals can be analog or digital radio signals. The device 100 can operate in one or more of simplex, half duplex, and full duplex transmission modes. The device 100 can accommodate access schemes such as time division multiple access (TDMA), frequency division multiple access (FDMA), code division multiple access (CDMA), narrowband CDMA (NCDMA), and broadband (or wideband) CDMA (BCDMA), ultra wideband orthogonal frequency division multiplexing (OFDM), for example, or any combination of such access schemes. The radio transceiver means 104 can be adapted to transmit and receive communications signals via any electromagnetic carrier, such as radio-frequency (RF), infrared, ultraviolet, or the like, or optically.

Preferably, the device is adapted to process, transmit, and receive packet-switched communications for compatibility with packet-based mobile communications networks and can be adapted to conform to any standard, or combination of standards, such as Universal Mobile Telecommunication System (UMTS), CDMA-2000, Bluetooth, and WiFi standards 802.11a, 802.11b, 802.11g. Thus, the device can provide communication access to a variety of network systems by adaptively switching to the appropriate access standard or scheme.

The device can communicate with (transmits signals to or receive signals from) a single base station, a plurality of base stations *(i.e.,* a network), or any number of external devices. Thus, a communications device 100 according to the invention can be a node on a telecommunications network, such as a cellular network or the internet, for example. The device 100 can transmit communications signals to, and receive communications signals from, one or more base stations in the network. Similarly, the base stations can transmit communications signals to, and receive communications signals from, the device 100. As the device moves from the proximity of a first base station into the proximity of a second base station, the first base station can automatically handoff the current communications link with the device (inbound or outbound communications; voice or data) to the second base station. Thus, the device 100 can remain in communication with the base stations (and, consequently, with the far-end device to which it is communicating) as the user moves. The device 100 can be an "always-on" device that provides permanent connections to external devices or networks.

Such a base station could be an external device that includes the communications electronics (*e.g.*, processor 102, antenna 104, *ete.).* The display communications device 100 could be electrically connected in communication with the base station. Thus, the base station can provide processing power and communications interfaces for the device 100. Such a base station could be stored in or integrated into an airplane, an automobile, a backpack, or the like.

The antenna 104 is electrically coupled to the processor 103. Preferably, the antenna 104 is coupled to an exterior portion of the housing 102. For example, the antenna 104 can be embedded into the housing 102 or affixed to the exterior of the housing 102. Alternatively, the antenna 104 can be coupled to an interior portion of the housing 102, and may be contained partially or completely within the housing 102. The device 100 could also be electrically connected to an external antenna. The external antenna could be plugged into the device and coupled to the electronic components in the device. Such an external antenna could be stored in a backpack, for example, so that a user could simply plug the antenna into the device whenever such use of the device is desired.

Preferably, the antenna 104 is adapted to transmit and receive broadband, audio/video signals for internet access and telephony. That is, the antenna is capable of transmitting and receiving full duplex data and voice, and provides broadband internet access. Preferably, the device 100 provides high speed, mobile access to the internet, and also includes pager and multi-media text messaging capabilities, such as may be provided via a multi-media messaging service ("MMS"), for example.

In a preferred embodiment, the device is capable of processing, and therefore, the radio transceiver means 104 is capable of transmitting and receiving, narrowband and/or broadband signals. Such broadband signals can be compatible with third-generation (3G) or fourth-generation (4G) digital radio standards, for example, though it should be understood that a device according to the invention can be adapted to conform to any standard or to multiple standards. Final standards for 3G broadband mobile wireless data transmissions via smart phones have been formally adopted by the ITU Radiocommunication Assembly by approval of the so-called IMT-2000 specification. In general, how the device accesses a wireless carrier is irrelevant. For example, it is anticipated that multi-network devices will be adapted to connect to the "right" network at the "right" time. That is, given that many networks will likely be available to the communications device at any given time, the device will attempt to connect to the network that is most appropriate for whatever the device is attempting to do at that time. For example, the device might seek the network that will yield the best reception, the most capability, the greatest bandwidth, or the like.

Preferably, the radio transceiver means 104 is adapted to transmit and receive radio signals having bandwidths of about 5 to 30 MHz, though it is anticipated that greater bandwidths might be used in future communications applications. Additionally, data rates of up to about 10 Mbps, or more, are anticipated.

The radio transceiver means 104 can include processing (either in the antenna itself or in the processor 103) for providing diversity. That is, the transmitting device can transmit the same signal a number of times (*e.g.*, three), and the receiving device can use the best of the signals that it receives. Additionally, the radio transceiver means 104 can be a smart antenna that includes processing (either in the antenna itself or in the processor 103) to measure, amplify, and otherwise optimize the input and output signals depending on the characteristics of the environment in which the signal is being transmitted or received.

The device 100 can also include ultra wideband software defined radio (SDR) capabilities, such as simultaneous use of airways, or spectrum shifting according to use, for example, computing power to further sub-divide radio signals based on their electrical or magnetic polarization, and can share national resources of the available radio spectrum. The device can also communicate using adaptive techniques, such as frequency-agile or hybrid communications techniques, for example.

The communications device 100 can also include a microphone for receiving input audio signals and one or more speakers for transmitting output audio signals. The speaker can be used to provide, for example, output audio signals that are received as part of a telephone conversation, output audio that is downloaded from the internet as part of a web page, or synthesized human speech produced by the device itself as a form of communication with the user. The speaker can also be used to provide identifiable sounds, such as, for example, a ringing sound if a call is incoming, or a tone (or series of tones) to indicate that a certain action has been taken (*e.g.*, the device has successfully connected to (or failed to connect to) an internet service provider). Such sounds could be synthesized.

Preferably, the communications device 100 includes a microtransceiver 108 having both a speaker (audio signal transmitter) and a microphone (audio signal receiver). The microtransceiver 108 is electrically coupled to the processor 103 and can be integrated/ embedded into the housing 102 or attached externally thereto. The processor 103 is adapted to extract audio data from the input radio signals, and to provide to the speaker output audio signals that are representative of the extracted audio data. The processor 103 is also adapted to form output radio signals based on input audio signals received from the microphone.

The device 100 can also include a wireless inductive transceiver 112 that provides audio to, and receives audio from, the user of the device. The wireless transceiver 112 can be a wireless earpiece, for example, that communicates with the processor via a wireless link 114. Preferably, the transceiver is an inductive transceiver that forms audio signals representing the user's speech based on the transceiver's detection of vibrations caused by the user's speech, for example. Thus, the processor 103 can convey audio signals to the transceiver 112, and the transceiver 112 can convey audio signals to the processor 103.

The display communications device 100 can include an A/D converter (as part of the processor 103 or external thereto), to which the microphone (or transceiver) is coupled. Analog audio signals from the microphone or transceiver are input to the A/D converter. The digitized output of the A/D converter is provided to the processor 103. The processor 103 then determines whether the device is in telephone mode (in which case the audio should be sent via the radio transceiver means 104), or in command mode (in which case the audio should be interpreted and an action taken in response). Thus, the microphone can be coupled to the processor 103, and used as an audio input means for both telephonic communications and to issue voice commands to the device 100.

Preferably, the processor 103 has the capability to understand and recognize human speech. Speech recognition techniques are fairly well known, and are becoming more and more common as computational power and the amount of available memory continues to increase. The user can speak to the device 100 either to transmit speech to a third party, or to give the device 100 a command. Preferably, a display communications device 100 according to the invention includes established verbal commands or keyboard actions to tell the processor 103 whether it is to transmit the input speech (*i.e*., that the device is in telephone mode) or to interpret the input speech as a command (*i.e.,* that the device is in command mode).

Such voice commands can include voice dialing capability, where the user can simply speak the telephone number he wishes to call, and the device will initiate a call to that number. Alternatively, the user can speak a code word (such as the name of the party he wishes to call). A list of such code words can be stored in memory, and associated with a respective telephone number or action. If the spoken code word is in the list, the device will initiate a call to the number associated with that code word. Similarly, the device 100 can use speech recognition as a security measure by permitting access to (any or all of) its functionality only if it detects that the voice of the user is the voice of an authorized user of the device.

If the processor 103 determines that the device 100 is in telephone mode, then the digitized audio signal can be compressed and encrypted, if desired, and input to a D/A converter and a modulator where an RF signal is modulated with the audio signal. The modulated RF signal is then passed to the antenna 104 where it is transmitted out of the device 100. If the processor 103 determines that the device 100 is in command mode, then the processor 103 performs speech recognition on the digitized audio input signal using well known speech processing techniques. The processor 103 can also include a command controller for causing an action to be taken in response to receiving a voice command. The device can also be coupled, preferably via a wireless link, to a central server or server pool that provides additional processing power for the device. Thus, more sophisticated and computationally intensive processing can be performed, without the need for increased processing power in the device itself.

Received radio signals can be passed from the antenna 104 through a demodulator, A/D converter, decryptor, and decompressor. Digital audio signals can be extracted from the received radio signals, and provided to the speaker for audio output.

Preferably, the housing 102 also contains a low voltage power supply 107, such as a rechargeable thin film battery. Such batteries are typically less than 10 microns thick, and can have open circuit voltages of about 2-5 V. The batteries can be cycled thousands of times, and can typically be operated at any temperature up to the melting point of lithium (180°C). U.S. Patent No. 5,895,731, entitled "Thin-Film Lithium Battery and Process" describes thin film lithium batteries and processes for making them. These batteries can be constructed in either prismatic or cylindrical configuration.

Alternatively, the device 100 can include a power generator, such as a methanol/hydrogen powered micro fuel cell, direct liquid micro ethanol fuel cell, or other such fuel cell technology. Such fuel cells typically use hydrogen to react with oxygen and produce an electrical current. Methanol is typically used in such fuel cells as it is known to be a good carrier fuel for the hydrogen that fuel cells need. Methanol-only micro fuel cells are being developed (by Motorola, for example) and it is anticipated that the use of such fuel cells might be advantageous in a display communications device according to the invention.

A solar power supply, such as a solar battery, for example, or any photovoltaic material that can convert sunlight into electricity, can also be used to provide electrical power to the device 100. Such a solar power supply may allow the device to operate on solar power alone. Preferably, a flexible, organic photovoltaic cell can be used. When the device is operating, additional power generated (by the solar power supply or micro fuel cell, for example) can be used to charge the battery. When the device is off, all power generated can be used to charge the battery.

According to the invention, an intelligent display system 106 can be coupled to the housing 102. The display system 106, which can be electrically coupled to the processor 103, can operate in conventional mode or intelligent mode. In conventional mode, the whole displayed is refreshed periodically (*e.g.*, 60-100 times per second for video applications; fewer for non-video graphical applications). In such an embodiment, conventional video processing electronics can be used to connect the display system 106 to the processor 103 (or other, external video source). If the display system 106 is operating in an "intelligent mode," then only updated information needs to be supplied to the display. In such an embodiment, the processor 103 can control the display 106 directly. The processor 103 can take the video input, process the information so as to detect changes in the display image from frame to frame, and then send out the appropriate video information to the display system 106.

The processing power for the display system 106 can be provided by the processor 103. In such an embodiment, the processor 103 can be adapted to compare the most recently received image *(i.e.,* the image to be displayed) with the previously received image *(i.e.,* the image that is currently being displayed). The processor 103 can then update individual pixels 109 as necessary.

An exemplary application in which a communications device according to the invention could be coupled to an external video source includes an application in which the device is used in conjunction with a security system (such as might be used in a department store, for example). One or more remote cameras (*i.e.,* remote to the communications device) could capture images at respective remote locations. The images could be transmitted (preferably wirelessly) to the communications device. The display system 106 could then provide to the user of the communications device, a video display that includes the images captured at the remote locations. The images could be provided full screen and automatically update from one camera to the next, or a number of such images could be displayed at the same time in separate windows on the display.

Alternatively, processing power could be provided locally to each pixel 109. For example, each pixel 109 could be programmed (or initialized) to know where it is relative to other pixels in the display. Unique addressing codes can be provided so that each pixel 109 knows what to display. Thus, the pixels 109 in an intelligent display system 106 can be viewed as nodes on a network. In such an embodiment, the processor 103 can provide display signals to the pixels 109. Preferably, a display signal includes an address that corresponds to a particular pixel (or group of pixels) and content that indicates what the addressed pixel (group) is to display. The pixel receives the signal and determines from the signal what it is to display. It is also contemplated that the processor can provide higher level information to the pixels. In such an embodiment, each pixel 109 can perform calculations on the higher level information to determine what it has to display.

A power system comprising one or more thin-film batteries or photovoltaic cells (or some combination of both) can also be attached to the display system 106. Such a power system could be attached to or directly deposited onto the backside of the display so that it does not interfere will the visual display provided thereon. Flexible thin film batteries or photovoltaic cells, for example, can be laminated onto the display. Thus, the device 100 can be powered by a first power system when the display system 106 is not extended, and also by a second power system that provides additional power or takes over for the first power system when the display system 106 is extended. Examples of flexible photovoltaic cells include organic, amorphous silicon, or copper indium diselenide. Preferably, where first and second power systems are provided, the power system attached to the display may not generate power unless the display is extended.

In a conventional display, driver electronics can provide the necessary information to each pixel 109 as to its brightness state. In an intelligent display, the pixels can be interconnected via a common data bus that carries data packets to the pixels. The data packets can include fields that have values that represent pixel location, color, and brightness. The data packet can provide either the physical or logical address of the pixel it is addressing, as well as the brightness state of that pixel. In such an embodiment, each pixel 109 can include circuitry to decode the address and brightness information.

According to one aspect of the invention, the display screen 110 can have a surface area that is larger than any cross-sectional area of the housing 102. Though the display screen can have a generally rectangular overall shape as shown, it should be understood that, in general, a display system 106 according to the invention has an unconstrained form factor. That is, the substrate onto which an intelligent display is formed can take on any shape.

Preferably, the display 106 is a high efficiency, interactive, multi-media display system. The display 106 should emit as much brightness as possible, with as little power consumption as possible, and can be a light transmissive or light reflective display. In a preferred embodiment of the invention, the display screen 110 comprises a plurality of pixels 109. Each pixel 109 comprises one or more light emitting elements. The pixels 109 can include organic materials, inorganic materials, or a combination of organic and inorganic materials. Preferably, the light emitting elements are high efficiency, organic light emitting devices (OLEDs) that use phosphorescent emitters such as disclosed in U.S. Patent No. 6,303,238 B1, which is hereby incorporated herein by reference in its entirety. Fluorescent emitters, such as those disclosed in U.S. Patents No. 4,539,507, 4,769,292, and 5,294,870 can also be used. The organic layers of the OLEDs can include small molecular (*i.e*., non-polymeric, unlinked) materials or large molecular (*i.e*., polymeric, linked) materials. The OLEDs can be ordinary, side by side OLEDs, or stacked (*i.e*., multiple resolution) OLEDs (SOLEDs). TOLEDs, which can be either transparent OLEDS or top-emission OLEDs, can also be used. Examples of TOLEDs are described in U.S. Patent No. 5,703,436, the contents of which are hereby incorporated herein by reference. Examples of SOLEDs are described in U.S. Patent No. 5,707,745, the contents of which are hereby incorporated herein by reference.

OLED devices are generally (but not always) intended to emit light through at least one of the electrodes, and one or more transparent electrodes may be useful in organic opto-electronic devices. For example, a transparent electrode material, such as indium tin oxide (ITO), may be used as the bottom electrode. A transparent top emission electrode, such as disclosed in U.S. Patent Nos. 5,703,436 and 5,707,745, which are incorporated by reference in their entireties, may also be used. For a device intended to emit light only through the bottom electrode, the top electrode does not need to be transparent, and may be comprised of a thick and reflective metal layer having a high electrical conductivity. Similarly, for a device intended to emit light only through the top electrode, the bottom electrode may be opaque and/or reflective. Where an electrode does not need to be transparent, using a thicker layer may provide better conductivity, and using a reflective electrode may increase the amount of light emitted through the other electrode, by reflecting light back towards the transparent electrode. Fully transparent devices may also be fabricated, where both electrodes are transparent. Side emitting OLEDs may also be fabricated, and one or both electrodes may be opaque or reflective in such devices.

The anode may be any suitable anode that is sufficiently conductive to transport holes to the organic layers. Preferred anode materials include conductive metal oxides, such as indium tin oxide (ITO) and zinc tin oxide (ZnTO), and metals. The anode (and substrate) may be sufficiently transparent to create a bottom-emitting device. A preferred transparent substrate and anode combination is commercially available ITO (anode) deposited on glass or plastic (substrate). A flexible and transparent substrate-anode combination is disclosed in United States Patent No. 5,844,363, which is incorporated by reference in its entirety. The anode may be opaque and/or reflective. A reflective anode may be preferred for some top-emitting devices, to increase the amount of light emitted from the top of the device. The material and thickness of the anode may be chosen to obtain desired conductive and optical properties. Where the anode is transparent, there may be a range of thickness for a particular material that is thick enough to provide the desired conductivity, yet thin enough to provide the desired degree of transparency. Other anode materials and structures may be used.

The substrate onto which the OLEDs are deposited may be any suitable substrate that provides desired structural properties. The substrate may be flexible or rigid. Plastic and glass are examples of preferred rigid substrate materials. Plastic and metal foils are examples of preferred flexible substrate materials. The substrate may be a semiconductor material in order to facilitate the fabrication of circuitry. For example, the substrate may be a silicon wafer upon which circuits are fabricated, adapted to control OLEDs subsequently deposited on the substrate. Other substrates may be used. The material and thickness of the substrate may be chosen to obtain desired structural and optical properties.

The display system 106 may also include a detachable protective layer disposed over the display screen to provide mechanical and environmental protection. Preferably, the protective layer is made of a thin, transparent material, such as plastic, for example, and can be easily replaced. Thus, such a protective layer can be disposable.

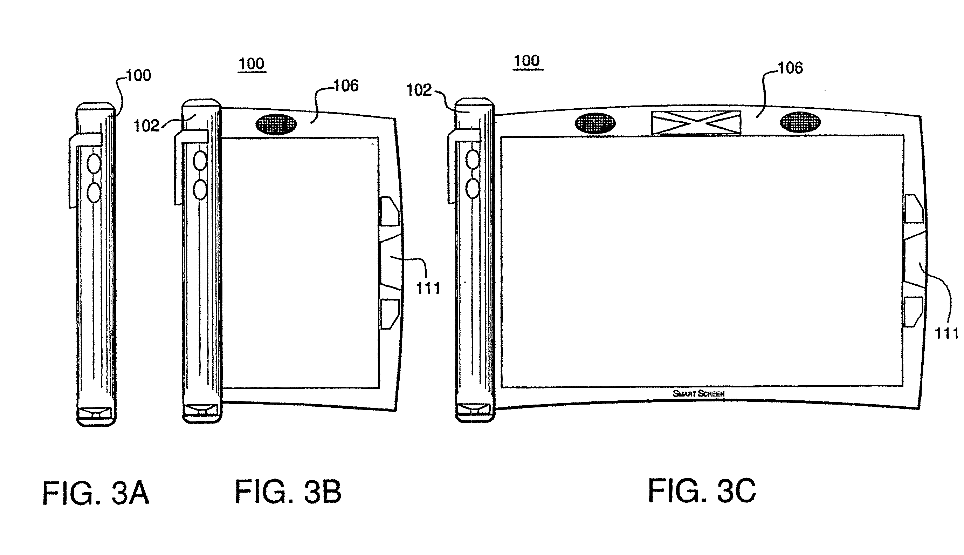

As depicted in FIGs. 3A-3C, the display 106 can be collapsible. That is, the display 106 can be formed on a collapsible substrate, and coupled to the housing 102 in such a manner that the display 106 can be pushed or pulled onto or into the housing 102. FIG. 3A shows the display 106 fully collapsed; FIG. 3B shows the display 106 partially extended; FIG. 3C shows the display 106 fully extended. It is contemplated that the display substrate can be formed from a smart material that is flexible when the display 106 is retracted, but becomes rigid when the display 106 is extended.

Thin film deposition processes can be used for depositing the pixels onto a collapsible substrate to form a collapsible display. Preferably, the display 106 is fabricated on a flexible substrate, such as plastic or thin metal foil.

Active-matrix backplanes that are compatible with plastic substrates can be fabricated, and deposited into the flexible substrate. The pixels can then be deposited thereon. Though active-matrix displays are preferred, it should be understood that passive-matrix displays can also be used in accordance with the principles of the invention. Active-matrix displays typically use transistors to keep their diodes in an on or off state. Passive-matrix displays, on the other hand, apply current to the diodes at a specific refresh rate to maintain an image.

OLED display technology is preferred for use on such flexible substrates because of, among other reasons, its very low substrate temperature during deposition, as well as its high brightness at low power levels. Small molecule OLEDs can be used, such as described in U.S. Patent No. 5,844,363, for example. Encapsulation to prevent moisture and oxygen from permeating through the plastic films and degrading the OLED performance is also preferably provided, for example, such as disclosed on U.S. Patent No. 5,771,562.

Flexible liquid crystal or field emission displays can also be used. For example, a flexible OLED backlight can be used to illuminate a flexible LCD to provide a flexible backlit LCD. Additionally, a flexible electrophoretic display medium, such as "Electronic ink," for example, that is processed into a film for integration into electronic displays can also be used. ("Electronic ink" is proprietary to E Ink Corporation.)

The display 106 can be formed as a flexible display that can be rolled around a rod 113, for example, such as shown in FIGs. 2A-2C. To extend the display 106, the user can simply unwind the display 106 from around the rod 113 (as shown in FIGs. 2A and 2B). To collapse the display 106, the user can simply wind the display 106 around the rod 113 (as shown in FIG. 2C).

In the embodiment depicted in FIG. 2A, the rod 113 is mounted inside the housing 102. In such an embodiment, one or both ends of the rod 113 can be rotationally coupled to interior ends of the housing 102. In the embodiment depicted in FIGs 2B and 2C, the rod 113 is mounted on the exterior of the housing 102. In such an embodiment, the rod 113 can be rotationally coupled to each of one or more coupling members 117. Each coupling member 117 can be attached (fixedly or rotationally) to the housing 102. The rod 113 can be fixedly or rotationally coupled to each of the one or more the coupling members 117. The display 106 can include an interface 119 for physically coupling the display 106 to the rod 113. The interface 119 can also provide a path for transporting electrical information between the display 106 and the rest of the device 100.

In still another embodiment, the display 106 can be rolled around the housing 102. As shown in FIGs. 2D and 2E, the display 106 can include an interface 120 for physically coupling the display 106 to the housing 102. The interface 120 can also provide a path for transporting electrical information between the display 106 and the rest of the device 100. To extend the display 106, the user can simply unwind the display 106 from around the housing 102 (as shown in FIG. 2D). To collapse the display 106, the user can simply wind the display 106 around the housing 102 (as shown in FIG. 2E).

Preferably, the display 106 is fabricated from materials that provide a display having as small a radius of curvature as possible. For example, the display 106 could be thin and flexible enough to roll or fold into a housing 102 that is about the size of an ordinary pen or pointer, or onto a rod that is connected to the housing, as discussed above. For example, the substrate should be thin enough so that the display, while retracted into the housing, for example, has as small a cross-sectional area as possible (transverse to the long direction of the rod). Similarly, the components that are deposited onto the substrate should be small enough and flexible enough to provide for a sufficiently small radius of curvature. OLED technology is preferred because of the very small pixel size that can be attained (such as the so-called "nanopixels," for example).

Preferably, the display 106 is auto-collapsible (much like a tape measure). For example, like a tape measure, tension can be placed on the rod 113 so that the display 106 will be wound around the rod 113 automatically unless the display 106 is locked into an extended position. The display 106 can also include an auto lock feature so that when the display 106 is fully extended, the locking mechanism is automatically latched. While the display 106 is locked, the user can cause the display 106 to wind around the rod 113 or housing 102 by unlatching the locking mechanism. For example, the locking mechanism can be a latch that can be set at any point, or which is automatically set when the display 106 is fully extended, or at any of a number of points while the display 106 is being extended. The display 106 can include an auto-collapse button 111 that, when pressed, causes the display 106 to collapse. For example, in an embodiment wherein the display 106 winds around a rod 113, the auto-collapse button 111 can cause the rod 113 to rotate and the display 106 to be wound around the rod 113. Alternatively, the auto-collapse button can release the locking mechanism, thereby causing the display to wind around the rod 113 or housing 102. The device 100 can also include a motor (not shown) that causes the display 106 to spool onto or off of the rod 113 or housing 102. Preferably, the motor is sized and shaped such that it can be contained within the housing 102.

The processor 103 is adapted to extract display data from the input radio signals, and to provide a representation of the display data to the display 106. In a preferred embodiment of the invention, the protocol for communications between the communications device 100 and external devices provides for a significant reduction in the required communications bandwidth relative to current communications protocols. For example, in a system according to the invention, information for every pixel 109 need not be transmitted continuously. Rather, each pixel 109 can be provided with enough "intelligence" to determine what it is expected to display based on higher level information that is provided via the communications from the outside world. Additionally, the display 106 can be updated by changing only those pixels 109 that need to be changed as the image changes. For backward compatibility, however, the device 100 preferably includes the capability to operate using existing protocols *(i.e.,* to translate from the old protocol to the new).

The display communications device 100 can also include a memory 105, which can be contained in the housing 102 or embedded into the display 106. Alternatively or additionally, the device 100 can include a removable memory, such as a memory card, and a miniature drive for reading from and writing data to the memory card. The memory can be used for temporary or permanent storage of audio, video, or other data that the communications device 100 receives, transmits, or uses during its operation. Such a memory could include, for example, a multi-mode memory card or "memory stick" that includes logic that provides multiple functionality for interfacing the communications device with different external devices.

Such a memory can also reduce the bandwidth requirement between the display system 106 and an external device by storing information about the current display. As a result, the processor 103 can pass only information that updates the display 106. In a preferred embodiment of an intelligent display, the display system 106 can include individual memory in each pixel 109. Basic memory cells, such as a few transistors, could be used to provide the required memory. The use of a few transistors at each pixel 109 reduces or eliminates the need to keep moving information from the outside to the pixel. Alternatively, an external chip could be used to make it easy for pixel memories to talk to one another.

The memory could be implemented as a large area electronic backplane, such as an active matrix display. For example, a pixel matrix could be overlaid on a backplane such that a number of transistors would be associated with each pixel. Currently, the display backplane is built first, and then the light emitting elements are deposited onto it. Typically, the display backplane includes electronics. In an intelligent display system according to the invention, additional electronics could be added for pixel-specific memory. Preferably, amorphous silicon, polysilicon, organic thin film technologies (TFTs), or other TFTs are used. Processing and logic could also be integrated into such a large area electronic backplane.

Preferably, a display communications device 100 according to the invention can be voice activated. For example, a user might want to display email or a flight schedule, to zoom into an image, or to move an image from one part of the screen to another. The user desiring to view his emails, for example, can simply command the device to show emails by speaking a command such as "show email" into the microphone. The processor 103 determines that the input audio is a voice command (rather than part of a telephone conversation). The processor 103 can include logic to receive the voice command, interpret it, and respond accordingly. For example, the processor 103 might retrieve the user's email from the user's email box, which can be stored in memory 105 in the communications device 100. Alternatively, however, the processor 103 can initiate an Internet connection to retrieve the user's email. In any event, the processor 103 causes the display 106 to display the user's email as a result of the user's voice activation command. In general, voice activation technology can be employed to cause the device 100 to perform any function that the device 100 can otherwise perform.

Additionally, voice activation may be used to actively configure the display device 106. For example, the user may speak "make call" or "type e-mail" and the display device 106 may auto-configure to display a phone keypad 132 or keyboard 134. Auto-configuration may be initiated by a using an engaging means located either on device 100 or display device 106.

The display 106 can have a display border 115, as shown, that can include a microphone 121, a speaker 123, and a digital imager 125. The imager 125 can include a thin film device that is integrated or embedded into the display screen 110. The imager 125 can be an organic or a small molecule polymer or hybrid inorganic detector. For example, each pixel 109 (or some subset of pixels) could have a sensing element to receive light within its field of view. Alternatively, through the use of large area imaging technologies, which can be implemented in software as part of the imager 125, the display screen 110 can, as a whole, be a combined video transmitted / receiver. In another embodiment of the invention, the imager 125 is separate from the display screen 110. For example, the imager 125 can be embedded into or attached onto the display border 115 or the device housing 102. In a preferred embodiment, the imager 125 is a thin film device that is thin enough and flexible enough so that the collapsible nature of the display 106 is unaffected. The imager can produce digital data corresponding to still photos or video. The digital data can be stored to memory (either to fixed memory in the housing 102 or to a removable memory card), and retrieved for later display. In this context, the device 100 can act like a digital camera or video camera.

A display communications device that includes such a digital imager can be used, for example, to provide gesture tracking. Such a device could capture images of a user gesticulating. A sequence of such images could then be compared to certain known commands (the mapping for which is stored in the device's memory or some remote memory location). For example, a user in distress could provide a sequence of gestures that, when translated, indicates the user's current location. The device could capture the sequence of images and translate the sequence into a message that includes the location of the user. Gesture tracking techniques, and software to perform them, are well known in the art.

The display 106 can include a speaker 123, if desired, so that a stereo effect can be achieved. When the display 106 is collapsed, the speaker 108 on the housing 102 provides output audio. When the display 106 is extended, however, the speaker 123 on the display 106 is automatically activated. As with the video imager, it is preferred that the speaker 123 is a thin film speaker that is thin enough and flexible enough so that the collapsible nature of the display 106 is unaffected.

Preferably, the display system 106 includes a touch responsive screen 110. In a touch responsive screen, components can be added into the screen itself, or overlaid on top of the screen 110, so that the device 100 can detect the presence and position of any touch input. For example, the user can use such a touch responsive screen, in conjunction with a stylus (or the user's finger) to write on the screen. The screen detects the touch of the stylus, and displays a contrasting color (or grayscale) where the stylus has met the screen. Additionally, the display system 106 can detect the writing and convey to the processor 103 coordinate data that corresponds to the pixels that have been "touched." The processor can then cause the coordinate data to be transmitted to a far-end communications device. The far-end device can then process the received coordinate data, and display the same writing on its screen as that displayed on the user's screen. Thus, the device can be used as an "electronic pen," via which a user of the device can transmit written information from his device to a far-end device.

Similarly, a set of several communication devices according to the invention can be communicatively linked and thereby used as a "team tool" that enables a group of users of the several devices to share information among the group. In a first such configuration, communications output from any device in the set can be provided to each of the other devices in the set, such that each of the users experiences the same information at his respective device. Alternatively, each of the devices in the set can be communicatively coupled to a single display, such that communications output from any device can be provided to the display. Preferably, the device is capable of providing three-dimensional images moving in real time. For example, holographic images can be provided for video conferencing and the like. Such a device can also include video game software.

A touch responsive screen also enables the display system 106 to detect and process user entered touch commands. This information can be used, for example, to activate switches displayed on the screen 110, or to highlight specific points on the display 106 (for example, as a zoom reference point).

The device 100 can also include fingerprint (including thumbprint) recognition as a security measure by permitting access to (any or all of) its functionality only if it detects that the user's fingerprint is that of an approved user. For such a purpose, the device can include a receptor (on the housing or the display system) that scans the user's fingerprint. The receptor communicates the fingerprint pattern to the processor, which includes processing for comparing the fingerprint pattern to one or more fingerprint patterns stored in memory. If the fingerprint pattern matches one of the stored patterns, then the user is authorized, and the device's functionality (or secure functionality) is enabled.

Similarly, the device can include retinal, iris, or other such eyeprint recognition as a security measure by permitting access to (any or all of) its functionality only if it detects that the user's eye is the eye of an approved user. For such a purpose, the device can include a receptor (on the housing or the display system) that scans the user's eyeprint. The receptor communicates the eyeprint pattern to the processor, which includes processing for comparing the eyeprint pattern to one or more eyeprint patterns stored in memory. If the eyeprint pattern matches one of the stored patterns, then the user is authorized, and the device's functionality (or secure functionality) is enabled.

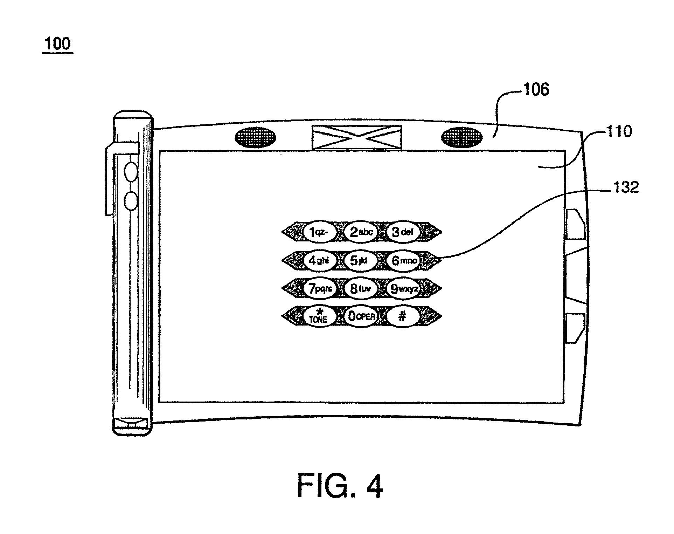

FIG. 4 depicts a preferred embodiment of a display communications device 100 according to the invention having a touch responsive display 106 with a telephone keypad 132. The user can use the telephone keypad 132 on the display 106 just as one would use the telephone keypad buttons of an ordinary telephone. The display system 106 detects the user's touch, determines which portion of the screen the user has touched, and communicates to the processor 103 a representation that indicates that the user has touched that portion of the screen. For example, each pixel can be assigned a coordinate representation (in the x-y plane, for example). When the user touches the display screen, the display system detects that certain pixels have been touched, and relays the corresponding coordinates to the processor. The processor 103 processes the touch commands according to which portion(s) of the screen the user has touched. For example, if the screen is currently displaying telephone keypad buttons, the processor can be programmed to initiate a telephone call to the "touched" telephone number.

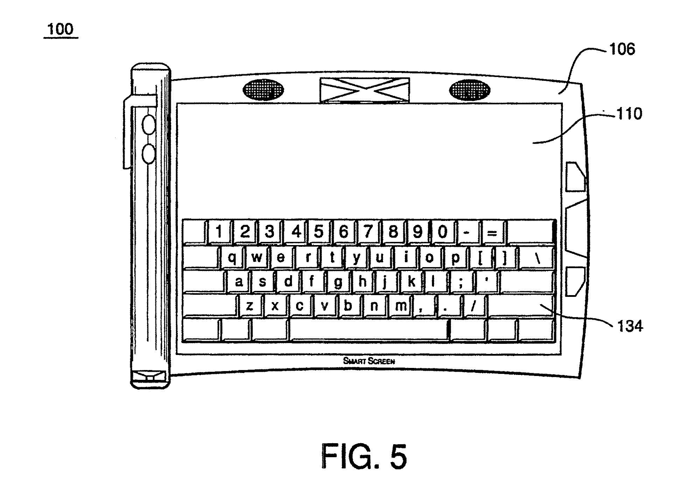

Similarly, FIG. 5 depicts a preferred embodiment of a display communications device 100 according to the invention having a touch responsive display 106 with a keyboard 134, such as one might find on a personal digital assistant or pager for example. The user can use the screen 110 as a keyboard for accessing the Internet, communicating via email, paging, etc. Again, the display system 106 detects the user's touch, determines which portion of the screen the user has touched, and communicates to the processor 103 a representation that indicates that the user has touched that portion of the screen. The processor 103 processes the touch commands according to which portion(s) of the screen the user has touched.

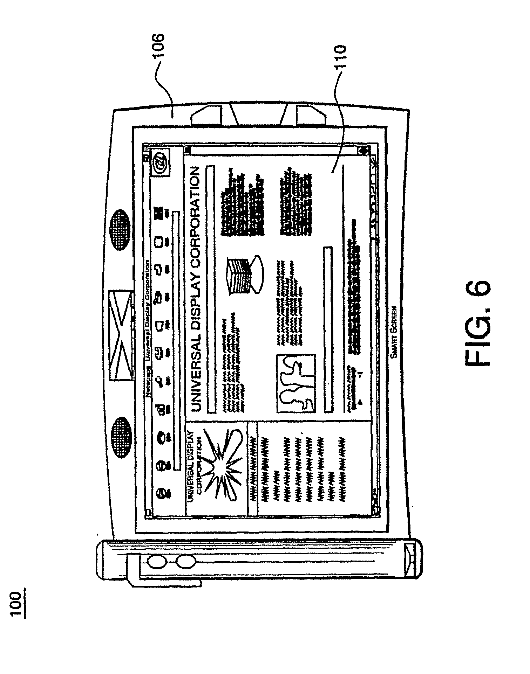

FIG. 6 depicts a preferred embodiment of a display communications device 100 according to the invention having a display screen 110 that is capable of displaying an entire Web page. Preferably, the display screen 110 provides full color display and is sized and shaped to display a Web page in a visually appealing format. The device can include browser software that enables the user to browse the Internet and download such web pages. The download technology can be applet or Java based, for example, or any other download technology can be used.

Preferably, the display system 106 can display multiple images on the display screen 110. That is, the display system 106 can provide split screen displays, such as those that might be downloaded from a web site, or can provide multiple active areas at the same time. For example, the display screen 110 can include a first sub-display (or window) that displays web pages as the user downloads them from the internet, and a second sub-display (or window) that displays the user's email at the same time. The user can move from window to window to interact alternatively with the internet or his email. Thus, a display communications device 100 according to the invention can be used to perform multiple functions concurrently.

Preferably, the display system 106 is self-configurable. In one configuration, the sub-display might change grayscale by changing the number of the 16 pixels that are on (or off) at a given time. The display can reconfigure itself as a matter of grayscale versus resolution based on to the needs of the image to be displayed. That is, the sub-display can reconfigure itself, based on whether a more precise grayscale or more resolution is desired for the current display. For example, for a particular image, four gray levels might be adequate but more resolution is desirable. In such an application, the 4x4 sub-display could reconfigure itself as four 2x2 sub-displays, each having four gray levels. Similarly, four 4x4 sub-displays could work together to form an 8x8 display having less resolution, but 64 gray levels.

In one embodiment, the display can include bistable pixels. A bistable pixel operates in a binary mode (*i.e.,* each pixel is either on or off), and stays in its current state until told to change. The pixels can include TFTs, or other electrical components, which can be connected to provide memory. The TFTs can be used to form conventional memory elements, which store data such as the associated pixel's location or brightness. If the information being displayed on the display is such that any specific pixel's brightness state does not need to change, then no information needs to be supplied to that pixel, and the internal local memory can retain the brightness information stored in the pixel memory. The local memory can then provide to the pixel circuit the information necessary to control the pixel brightness.

The bistable pixels can include organic or inorganic photodetectors as part of the bistable circuit. Additionally, the bistable pixels can be made using purely electrical feedback. Examples of bistable pixels for use in such a display are provided in U.S. Patent Application No. 10/219,760, filed August 16, 2002, entitled "An Organic Photonic Integrated Circuit Using An Organic Photodetector An A Transparent Organic Light Emitting Device," the disclosure of which is hereby incorporated herein by reference.

In such a display, gray-scale can be achieved by defining each pixel as a group of sub-pixels (for example, 4, 8, 16, or 64), and turning on or off the appropriate number of sub-pixels. Thus, the display can be used at maximum resolution, with each pixel either on or off, or at lower resolutions, with each pixel displaying gray scale information.

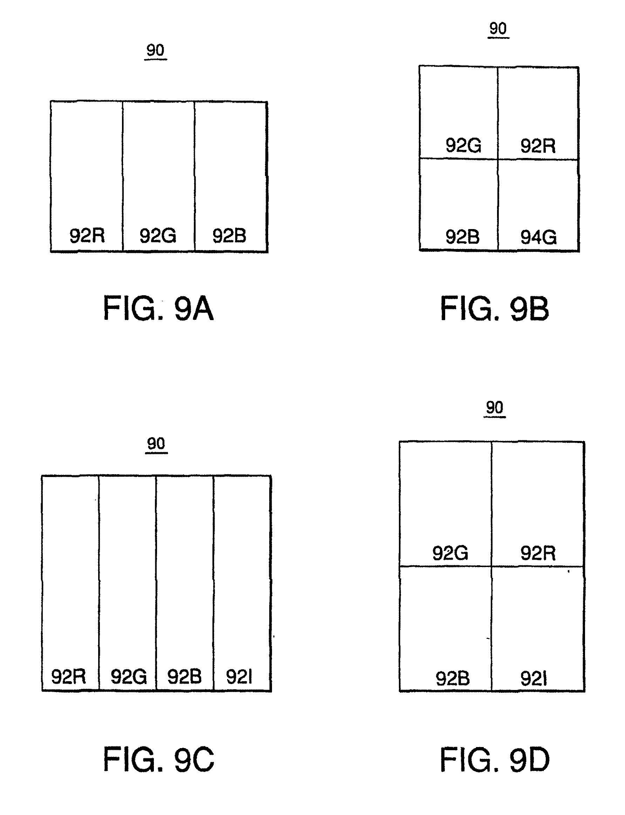

In a color display, each pixel can include three sub-pixels - one for each of the primary colors (*i.e*., red, blue and green). As shown in FIG. 9A, a pixel 90 can be arranged as a 1x3 matrix of sub-pixels 92R, 92G, 92B. That is, the three colored sub-pixels 92R, 92G, 92B can be arranged linearly. Thus, each sub-pixel 92R, 92G, 92B on the display 106 can be addressed using the same number of row lines, for example, as if each pixel 90 had a single address (*e.g.*, in a monochrome display), with three times the number of column lines.

Another well-known pixel arrangement is the so-called "quad-green" architecture. In this embodiment, which is depicted in FIG. 9B, the pixel 90 includes a second green sub-pixel 94G in addition to the other primary colored sub-pixels 92R, 92B, 92G. The sub-pixels 92, 94 are arranged in a 2x2 matrix as shown. Thus, each sub-pixel 92, 94 on the display 106 can be addressed with twice the number of row lines and twice the number of column lines as if each pixel 90 had a single address.

Normally, it will be desirable for the display 106 to be a visible as possible. However, there certain applications in which it might be desirable for the display 106 not to be seen by the unaided human eye. To accommodate such applications, the display system 106 can also include the use of infrared (IR) pixels so that at night, the display 106 can only be seen using infrared sensing equipments, such as night vision goggles, for example. The display system 106 can include a pixel architecture, such as depicted in FIGs 9C and 9D, for example, that includes four sub-pixels: one green 92G, one red 92R, one blue 92B, and one infrared 92I. In such an embodiment, power can be supplied to all sub-pixels all the time or, to reduce power consumption, only to the colored sub-pixels 92G, 92R, 92B when color is desired, and only to the infrared sub-pixels 921 when color is not desired. As shown in FIG. 9C, the sub-pixels 92, 94 could be arranged linearly, or, as shown in FIG. 9D, the sub-pixels 92, 94 could be arranged in a 2x2 matrix.

It is also contemplated that a display system 106 according to the invention can be detachably coupled or removably connected to the housing 102, as well as to any number of external devices, such as portable phones, laptop or personal computers, personal digital assistants (PDAs), internet appliances, televisions, or the like. In this context, the display system 106 can be coupled to an external device in any fashion that provides for the transfer of information, either directly or remotely, between the display system 106 and the external device. Examples of wireless connectivity that could be used for this purpose include, without limitation, radio, optical, infra-red, or other such communications carriers. In such an implementation, the display system 106 can be adapted to determine an identity of the external device to which it is communicating, and to respond accordingly. For example, the user of an intelligent display system according to the invention can connect the display system 106 to a cellular phone (or other such external device). Thereafter, the display system 106 assumes the attributes of the display included with the external device, and thus can provide a better display than the display included with the external device.

In these cases the display system 106 recognizes the display characteristics of the system to which it is connecting. For example, if the display system 106 were connected to a cell phone, it could determine the resolution and gray scale content, for example, of the cell phone display. The display system 106 could then adjust the image of the cell phone display so that it could be viewed appropriately at different sizes. Each pixel of the cell phone display could be mapped onto a corresponding pixel 109 in the display system 106. Alternatively, if a larger or more resolute image is desired, each pixel from the cell phone could map onto a plurality of pixels of the display system 106.

Similarly, the display could be detachably coupled to the housing so that any of a number of displays could be coupled to the housing at a given time. For example, a user of the device might wish to use a certain display (having a first display resolution, say) under certain circumstances, but a different display (having a better resolution) under different circumstances.

The display communications device 100 can also include location finding capabilities, such as global positioning. For example, the antenna 104 can receive global positioning signals from one or more global positioning satellites. The processor 103 can then determine the location of the device 100 from the global positioning signals. The processor 103 can pass data to the display system 106 so that the display system 106 can provide a visual representation of the location of the device 100 based on the received global positioning signals.

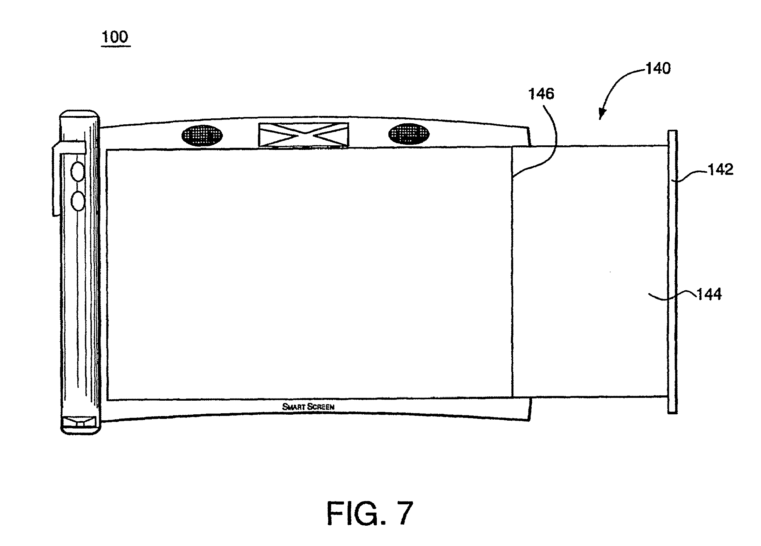

Figure 7 depicts a preferred embodiment of a display communications device 100 according to the invention that includes a display system extension 140. As shown, the display extension can also be collapsible. Preferably, the display system extension 140 includes a collapsible display screen extension 144. The display screen extension 144 can be made as described above in connection with display system 106. Preferably, the display screen extension 144 can be wound around a rod (not shown) that is contained within an extension housing 142. Thus, a display communications device 100 having a display system extension 140 can take the form of a "pen and pencil" set.

The display system 106 and the display system extension 140 are coupled to one another via a display extension interface 146. When the display system extension 140 is coupled to the display system 106, the device 100 detects that the display system extension 140 is present. Thereafter, the processor 103 can provide display data for both the display system 106 and the display system extension 140. For example, a display data bus can extend through the display system 106, culminating at the display extension interface 146. Similarly, the display system extension 140 can include a display data bus that also culminates at the display extension interface. Thus, the processor can communicate display data to both the display system 106 and the display system extension 140 via a common bus. The display extension 140 can also include additional memory.

Information input/output to/from the device could be accomplished by way of the extendable display system described above, and also by way of a low-information display system that is disposed on the exterior surface of housing 100. The display system could be communicatively coupled to the processor 103, and be sized and shaped such that it can display telephone numbers, names, and the like.

The device 100 may also be removably connected to a micro-display, which can be incorporated into a user's headset, eyeglasses, etc., or to a wrist-wearable device, such as a watch, for example, to thereby provide greater privacy for the user while the device is in use. The device 100 may also be connected to an automobile's heads-up display (HUD) or a Transparent Organic Light Emitting Device (TOLED) display, to display information onto an automobile windshield, for example.

The device can also include a keypad disposed on the housing. The keypad could be communicatively coupled to the processor 103, and be sized and shaped such that the user can enter telephone numbers, text, data, or the like (perhaps with the aid of a pin or pencil point). Thus, the device can be operated without the need for the main display system 106 to be extended. Similarly, the device 100 may be coupled to an external input or output device, such as a keyboard, mouse, display, *etc.,* in any fashion that provides for the transfer of information, either directly or remotely, between the display system 101 and the external input or output device.

It is also anticipated that the device can be used as a remote control device to control external devices such as lighting, stereo, televisions, appliances, and the like. The device can be programmed (either pre-programmed or by the user) such that the user can press the appropriate button(s) on the device and thereby cause the device to transit the appropriate signal, preferably infrared, to control the external device.

In alternative embodiments of the invention, the communications device can also include a collapsible housing. Using any of the techniques described above, the display could be coupled to the exterior of the housing and wound around a rod or the housing itself, or the display could be coupled to the interior of the housing so that the display can be retracted into the housing and the housing wound on itself.

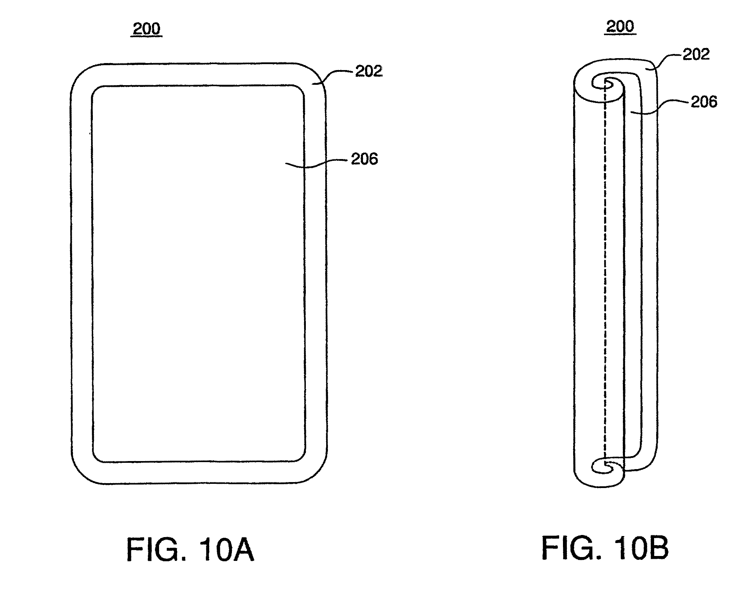

As depicted in FIGs. 10A and 10B, the display system 206 can be integrated into or onto a collapsible housing 202. In such an embodiment, the device 200 could be made to resemble a conventional PDA, as shown in FIG. 10A for example. However, according to the invention, both the housing 202 and the display 206 could be collapsible such that a user can roll the entire device 200 onto itself (as shown in FIG. 10B).

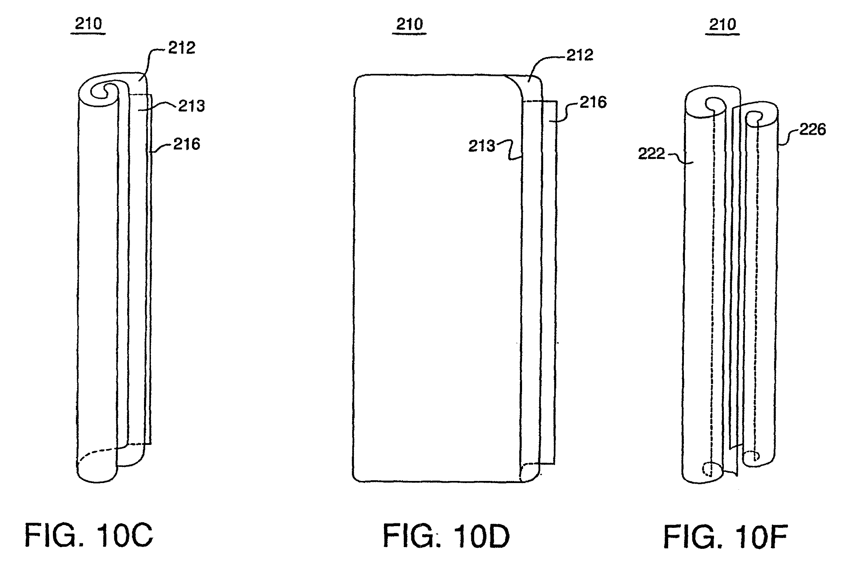

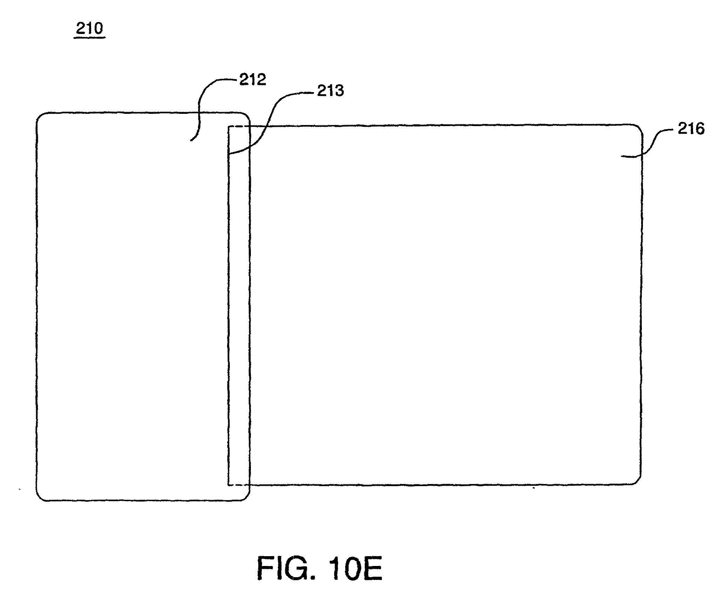

As depicted in FIGs. 10C-10E, a communications device 210 can include a collapsible housing 212 and a collapsible display 216 that can be stored at least partially within the housing 212 (as shown in FIGs 10C and 10D) or extended out of the housing 212 (as shown in FIG. 10E). The collapsible display 216 can be coupled to the collapsible housing 212 via a rod 213 which can be rotationally coupled to an interior portion of the housing (as shown in FIGs. 10C-10E) or to an exterior portion of the housing (such as depicted in FIGs. 2B and 2C, for example).

As shown in FIG. 10C, the housing 212 can be collapsed with the display 216 stored at least partially inside the housing 212. The housing 212 could be unfurled, as shown in FIG. 10D, while the display 216 remains at least partially inside the housing 212. The display 216 could then be extended out of the housing 212 as shown in FIG. 10E.

As depicted in FIG. 10F, a communications device 220 can include a collapsible housing 222 and a collapsible display 226 that is attached to the collapsible housing 222 such that each of the collapsible display 226 and the collapsible housing 222 can be wound onto itself.

Thus, there have been described interactive, low power, collapsible, intelligent, multi-media display systems for use as hand-held, portable communications devices. Those skilled in the art will appreciate that numerous changes and modifications can be made to the preferred embodiments of the invention, and that such changes and modifications can be made without departing from the spirit of the invention. It is intended, therefore, that the appended claims cover all such equivalent variations as fall within the true spirit and scope of the invention.

Aspects of the disclosure of the present application are set out in the following clauses.
1. A display communications device comprising:
   a housing;
   means for receiving input communications signals; and
   a collapsible display for providing a visual display based on the input communications signals, wherein the collapsible display is coupled to the housing and has a surface area that is larger than any cross-sectional area of the housing.
2. The display communications device of clause 1, further comprising:
   a processor that is adapted to extract display data from the input communications signals, and to provide a representation of the display data to the collapsible display.
3. The display communications device of clause 2,wherein the processor is contained within the housing.
4. The display communications device of clause 1, wherein the collapsible display is operable for receiving user input data, the device further comprising:
   means for transmitting output communications signals based on the user input data.
5. The display communications device of clause 1, further comprising:
   a first power supply attached to the collapsible display.
6. The display communications device of clause 5, wherein the first power supply includes a thin film battery.
7. The display communications device of clause 5, wherein the first power supply includes a photovoltaic cell.
8. The display communications device of clause 5, wherein the first power supply includes a fuel cell.
9. The display communications device of clause 5,wherein the housing contains a second power supply.
10. The display communications device of clause 9, wherein at least one of the first power supply and the second power supply includes a thin film battery.
11. The display communications device of clause 9, wherein at least one of the first power supply and the second power supply includes a photovoltaic cell.
12. The display communications device of clause 9, wherein at least one of the first power supply and the second power supply includes a fuel cell.
13. The display communications device of clause 1, further comprising:
   a removable transparent material disposed on a surface of the collapsible display.
14. The display communications device of clause 13, wherein the removable transparent layer includes a plastic film,
15. The display communications device of clause 1, wherein the display comprises a pixel, the pixel having an infrared sub-pixel.
16. The display communications device of clause 15, wherein the pixel comprises a colored sub-pixel.
17. The display communications device of clause 16, wherein the pixel comprises red, green, blue, and infrared sub-pixels arranged in a linear relationship.
18. The display communications device of clause 16, wherein the pixel comprises red, green, blue, and infrared sub-pixels arranged in 2x2 matrix.
19. The display communications device of clause 1, further comprising:
   means for receiving global positioning signals.
20. The display communications device of clause 1, further comprising:
   a keypad disposed on an exterior surface of the housing.
21. The display communications device of clause 1, further comprising:
   a second display disposed on an exterior surface of the housing.
22. The display communications device of clause 1, further comprising:
   an electrical interface for receiving user input signals from an external user input device.
23. The display communications device of clause 22, further comprising:
   a mechanical interface for connecting the external user input device to the display communications device.
24. The display communications device of clause 1, further comprising:
   an electrical interface for providing display signals to an external display.
25. The display communications device of clause 24, further comprising:
   a mechanical interface for connecting the external display to the display communications device.
26. The display communications device of clause 1, further comprising:
   means for attaching the collapsible display to the housing such that the display can be wound around the housing.
27. The display communications device of clause 26, wherein the collapsible display is a flexible display.
28. The display communications device of clause 1, further comprising:
   means for attaching the collapsible display to an exterior portion of the housing.
29. The display communications device of clause 28, further comprising:
   a rod that is coupled to the exterior portion of the housing such that the collapsible display can be wound around the rod.
30. The display communications device of clause 1, further comprising:
   means for attaching the collapsible display to an interior portion of the housing.
31. The display communications device of clause 30, further comprising:
   a rod that is coupled to the interior portion of the housing such that the collapsible display can be wound around the rod.
32. The display communications device of clause 1, further comprising:
   a fan contained in the housing.
33. The display communications device of clause 1, further comprising:
   means for performing fingerprint recognition of a user of the device.
34. The display communications device of clause 1, further comprising:
   means for performing eyeprint recognition of a user of the device.
35. The display communications device of clause 1, further comprising:
   means for processing encrypted input communications signals.
36. The display communications device of clause 1, further comprising:
   an antenna that is coupled to an exterior portion of the housing.
37. The display communications device of clause 1, further comprising:
   an antenna that is coupled to an interior portion of the housing.
38. The display communications device of clause 1, further comprising:
   an antenna interface for coupling the device to an external antenna.
39. The display communications device of clause 1, wherein the display comprises a plurality of organic light emitting devices (OLEDs).
40. The display communications device of clause 39, wherein the display comprises a plurality of phosphorescent OLEDs.
41. The display communications device of clause 1, wherein the display comprises a plurality of transparent organic light emitting devices.
42. The display communications device of clause 1, wherein the display comprises a plurality of top-emission organic light emitting devices.
43. The display communications device of clause 1, wherein the display comprises a plurality of encapsulated organic light emitting devices.
44. The display communications device of clause 1, further comprising a video imager that is integrated into the housing.
45. The display communications device of clause 27, wherein the display is fabricated on a flexible substrate.
46. The display communications device of clause 45, wherein the flexible substrate comprises plastic.
47. The display communications device of clause 45, wherein the flexible substrate comprises metal foil.
48. A display communications device comprising:
   a housing;
   a collapsible display that is coupled to the housing and has a surface area that is larger than any cross-sectional area of the housing, wherein the collapsible display is operable for receiving user input data; and
   means for transmitting output communications signals based on the user input data.
49. The display communications device of clause 48, wherein the display includes a touch-responsive display screen.
50. The display communications device of clause 48, wherein the display includes a fingerprint sensor for detecting a fingerprint of a user of the device.
51. The display communications device of clause 48, wherein the display includes a voice-activated display screen.

## Claims

1. A hand-held display comprising:
a housing:
a processor configured to provide display data; and
a collapsible display for providing a visual display on the display data,
wherein the collapsible display is coupled to the housing and has a surface area that is larger any cross-sectional area of the housing, and wherein the display is an active matrix display, is flexible, is rollable into the interior of the housing, wound more than one complete revolution upon and comprises a plurality of organic light emitting devices (OLEDs) deposited onto a flexible active-matrix backplane.

2. The device of claim 1, further comprising: a first power supply attached to the collapsible display, the first power supply including a thin film battery, a photovoltaic cell, and/or a fuel cell,

3. The device of claim 2, wherein the housing contains a second power supply, the second power supply including a thin film battery, a photovoltaic cell, and/or a fuel cell.

4. The of any of claim 1 to 3, further comprising: a rod that is coupled to the interior portion of the housing such that the collapsible display can be wound around the rod.

5. The device of any of claims 1 to 4, further comprising: means for performing fingerprint recognition of a user of the device, means for performing eyeprint recognition of a user of the device, and/or means for processing encrypted signals.

6. The device of any of claim 1 to 5, wherein the display comprises a plurality of phosphorescent OLEDs.

7. The device of any of claims 1 to 5, wherein the display comprises a plurality of transparent organic light emitting devices.

8. The device of any of claims 1 to 5, wherein the display comprises a plurality of top-emission organic light emitting devices.

9. The device of any of claims 1 to 5, wherein the display comprises a plurality of encapsulated organic light emitting devices.

10. The device of any of claims 1 to 9, wherein the flexible substrate comprises metal foil and/or plastic.

11. The display device of any of claims 1 to 10, wherein the display includes a plurality of pixels, each pixel having a colored sub-pixel and an infrared sub-pixel.

12. The display device of claim 11, wherein each pixel comprises red, green, blue, and infrared sub-pixels arranged in a linear relationship or a 2x2 matrix.

13. The display device of claim 11 or 12, wherein the display device is configured to operate in at least two modes including a) a first mode, wherein power is provided to the colored sub-pixels to allow the visual display to be seen by an unaided human eye, and b) a second mode, wherein power is supplied to the infrared sub-pixels but not to the colored sub-pixels to allow the visual display to be seen only if infrared-sensing equipment is used.

14. The display device of claim 13, wherein power is not provided to the infrared sub-pixels in the first mode.

15. A device comprising:
a housing;
a processor configured to provide display data; and
a display coupled to the housing for providing a visual display based on the display data, wherein the display is an active matrix display and comprises a plurality of light emitting devices (OLEDs) deposited onto an active-matrix backplane, and wherein the display includes a plurality of pixels, each pixel having a colored sub-pixel and an infrared sub-pixel.
